# EUROPEAN PATENT SPECIFICATION

(11) **EP 0 559 995 B1**
(45) Date of publication and mention of the grant of the patent: **16.09.1998**
(21) Application number: 92830115.9
(22) Date of filing: 11.03.1992
(51) Int. Cl.: G11C 16/06

(54) **Decoder circuit capable of transferring positive and negative voltages**
Dekodierschaltung fähig zur Ubertragung von positiven und negativen Spannungen
Circuit décodeur capable de transférer des tensions positives et négatives

(43) Date of publication of application: 15.09.1993
(73) Proprietor: STMicroelectronics S.r.l., 20041 Agrate Brianza (Milano) (IT)
(72) Inventor: Gastaldi, Roberto, I-20139 MILANO (IT)
(74) Representative: Pellegri, Alberto

(56) References cited:
- EP-A- 356 650
- EP-A- 443 610
- US-A- 5 077 691
- PATENT ABSTRACTS OF JAPAN vol. 015, no. 507 (P-1291)20 December 1991 & JP-A-3 219 496 ( HITACHI ) 26 September 1991

## Description

### FIELD OF THE INVENTION

The present invention relates to electrically erasable, programmable memories, in particular of a FLASH-EPROM type, with a high density of integration and more specifically to a decoding circuit for word lines capable of transferring voltages to the lines of a first sign during programming and reading phases and a voltage of opposite sign during erasing phases, which may be directly integrated among other circuit components, commonly utilizing a supply voltage of a certain sign, in the same semiconducting substrate.

### BACKGROUND OF THE INVENTION

Notably erasing of a common nonvolatile memory of the FLASH-EPROM type may be performed by connecting a gate terminal of the memory cells to ground and a source terminal of the memory cells to a sufficiently high voltage, commonly of about 12 V. This method is relatively simple to implement circuitally, but has the drawback of subjecting the source junction of the memory cells to a strong electric field which may generate a current of nonnegligeable level across the source/substrate junction and an injection of hot carriers (i.e. electric charges which are accelerated up to a relatively high kinetic energy) into the dielectric gate-isolation layer (e.g. the gate oxide layer). These mechanisms jeopardize the reliability of the memory when it is subjected to a relatively high number of programming/erasing cycles.

In order to avoid this undesired consequence, the possibility of erasing the cells of a common FLASH-EPROM memory by applying a negative voltage to the control gate in order to reduce the electric field intensity across the source junction has been taken into consideration by many authors (re: H. Kume et al. "A 3.42µm Flash Memory Cell Technology ..." 1991 Symp. on VLSI process; N. Kodama et al. "A 5V only 16 Mb Flash Eprom Cell ..." 1991 Symp. on VLSI process). The best approach appears that of subdividing the erasing voltage between the control gate and the source terminals of the memory cells, e.g. by applying to the control gate a negative voltage of about -9V and to the source a positive voltage of about +5V, though other subdivisions of the voltage are possible.

The document US-A-5,077,691 discloses a FLASH-EEPROM cell employing negative voltage during erase operation.

EP-A2-0443610 discloses an EEPROM memory device wherein the peripheral circuit is formed in a double-well region.

Unfortunately, when this approach of preservation of the integrity of the memory cells during erasing which may be conducted on the entire memory's matrix or on selectable sectors thereof, is followed, the decoding circuitry must be designed in a manner as to be capable of utilizing (transferring) voltages of opposite signs: e.g. positive voltages during programming and reading phases or negative voltages during erasing phases of the memory). According to the known technique, this implies a remarkable circuit complexity. Therefore the portion of the decoding circuit which is destined to transfer a voltage of opposite sign to the sign of the supply voltages of the circuit and of the sign of the voltage which is eventually applied to the selected lines during programming and reading phases, must be necessarily separated from the rest of the decoding circuitry and this duplication-separation of circuits complicates the overall decoding circuitry and requires additional chip area which may be unacceptable in many cases.

### OBJECTIVE AND SUMMARY OF THE INVENTION

Therefore there is the need or utility for a decoding circuit, in particular for a word line decoding circuit, capable of trasferring positive voltages as well as negative voltages while being monolithically integratable together with other parts of the decoding circuitry normally employed for making the entire decoding system, in the same semiconducting substrate.

This objective and related advantages are achieved by the decoding circuit for word lines of the present invention as specified in claim 1. Basically this result is reached by employing as a transfer device of a voltage of the desired sign and level to a selected word line an inverter to an input node of which a selectable voltage signal may be applied and whose output node is connected to a respective word line of the memory matrix and wherein the driver transistor of the inverter is functionally connected to a first supply node of the inverter onto which the ground potential of the circuit may be switched, during programming and reading phases of the memory, or a different voltage of a certain sign, e.g. a negative voltage, may be switched, during an erasing phase of the memory. The driver transistor of the inverter is formed within a region of the semiconducting substrate having an appropriate type of conductivity (e.g. the same type of conductivity of the substrate), which is entirely contained within a larger region of the semiconductor having a conductivity of opposite type then that of said first inner region and wherein a complementary (load) transistor of the inverter, which is functionally connected to the other supply node of inverter, onto which different voltages of the same sign of the supply voltage of the rest of the circuit may be switched, is formed. In practice, the driver transistor of the inverter is formed inside a well-region which is effectively isolated electrically from the common semiconducting substrate of the other transistors of the same type of conductivity forming the rest of the decoding circuitry. The voltage of an opposite sign to the sign of the common supply voltages of the circuit (e.g. a negative erasing voltage) may be generated by a normal voltage-pump circuitry, which may be enabled by means of a control signal and the voltage delivered through an output node of the voltage pump circuit, may be switched to the respective supply node of the transfer inverter in lieu of the ground potential of the circuit (during an erasing phase) by means of an appropriate voltage switching circuit. Also transistors forming such a voltage switching circuit and which may be connected to such a voltage of opposite sign may be formed in an isolated well-region purposely formed within a larger tub-region of an opposite type of conductivity into which complementary transistors of the voltage switching circuit may be formed. Naturally, an unique isolated well-region, formed within a larger tub-region of a type of conductivity opposite to the type of conductivity of the semiconducting substrate in which the circuit is formed, may advantageously contain both the driver transistor of the voltage transfer inverter and the transistors of the same type of conductivity which compose an eventual voltage switching circuit, used for selectively switching either the ground potential or a voltage of such an opposite sign to the respective supply node of the transfer inverter.

### BRIEF DESCRIPTION OF THE DRAWINGS

The different features and advantages of the circuit of the invention will become evident through the following description of preferred embodiments and reference to the attached drawings, wherein:
**Figure 1** is a fragmentary simplified block diagram of the general organization of a word line decoding circuit of a memory;
**Figure 2** shows a circuit diagram of a selection block for a plurality of word lines;
**Figures 3** and **4** functionally depict a voltage transferring inverter used within the decoder blocks of Figures 1 and 2, in a phase of transferring through an output node a ground potential of the circuit and a negative erasing voltage, respectively, to a word line;
**Figure 5** is a symbolic vertical cross section of the transfer inverter of Figures 3 and 4, made in accordance with the present invention;
**Figure 6** is a simplified circuit diagram of a voltage switching circuit capable of driving a supply node of the inverter shown in the preceding figures.

### DESCRIPTION OF THE PREFERRED EMBODIMENTS

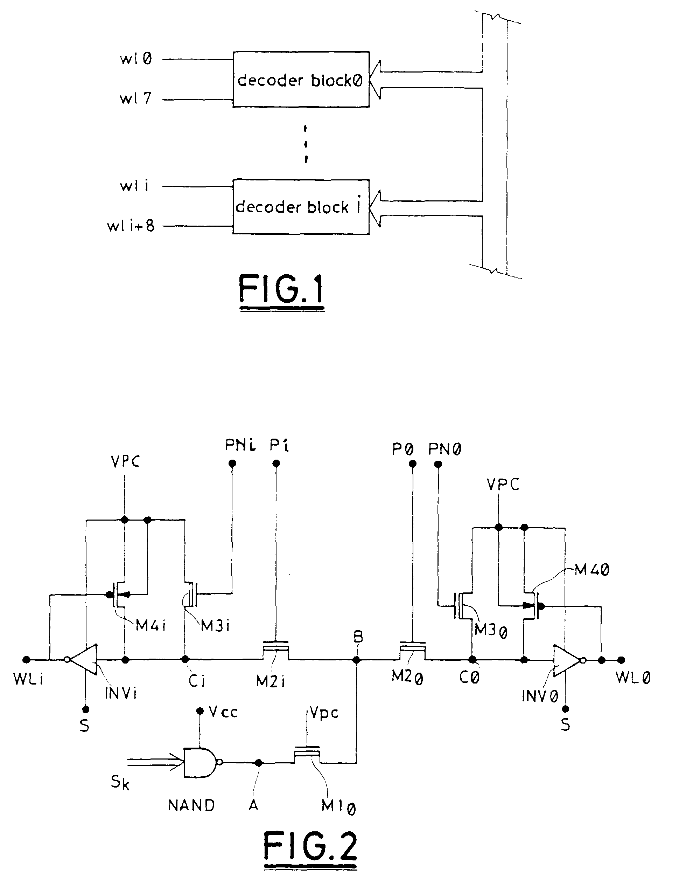

The block diagram of **Fig. 1** shows the general organization of a decoding circuitry for word lines, comprising **n** blocks, each being selected by a particular binary combination of the **k** selection signals **(S**_{**k**}). Naturally, between the number n of blocks and the number **k** of selection signals applies the known relation: **n = 2**^{**k**}**.**

In the example shown, each block is capable of selecting eight word lines, among which, thanks to secondary selection signals, which may be called: **Pi** and **PNi** (where **i = 0,7**), a certain word line of the memory cell matrix is eventually selected in the way which will be described later. By duplicating this structure as many times as necessary to cover the entire number of word lines of the memory matrix, a complete decoder is realized.

A typical circuit of a decoder block is depicted in **Fig. 2.** It should be noted that each block comprise a circuit portion which is common for all the word lines managed by the block (e.g. **8**) which is constituted by the transistor **M1**0̸ and by the **NAND** gate which drive the node **B** to which as many identical driving circuits as the actual number of lines managed are connected. In the diagram of **Fig. 2** two of said identical circuits are shown, a first one for the line **WL0̸** and the other for another generic line **WLi**, as this is sufficient to fully illustrate the operation of any decoder block.

For purely illustrative purposes, the whole circuit, with the exclusion of the **NAND** gate, is shown as being supplied by a voltage **VPC**, which may be equal to +**5V** (± **10%**), during a reading and during an erasing phase, or be equal to +**12V** (± **10%**) during a programming phase of the memory. By contrast, the **NAND** gate is supplied by the supply voltage **VCC**, which may have the value of +**5V** (± **10%**), in all conditions. These are relatively standard supply conditions for commercial memories.

The operation in a reading or programming phase of the decoding circuit of **Fig. 2** may be described as follows. If the word line **WL0̸** must be selected for reading or programming a byte of memory, the voltage on the word line **WL0̸** must be brought to a high logic value **"1"**, while all the other lines must remain at a low logic level "**0̸**". In order to achieve this, the Block **0̸** (**Fig. 1**) is selected by means of the selection signals **S**_{**k**} which are fed to the relative **NAND** gate of the block (**Fig. 2**). In this way, the node **A** is brought to a "**0̸**" logic state and, through the transistor **M10̸** which is conducting, also the node **B** is brought to a "**0̸**" logic state.

At this point, line selection is performed by means of the complementary pair of secondary selection signals: **P** and **PN**. Precisely for the case analysed, the signal **P0̸** is brought to a high logic level "**1**" and the relative inverted signal **PN0̸** takes a low logic level "**0̸**", while the opposite takes place for the other seven pairs of signals (**Pi** and **PNi**), pertaining to the other lines managed by the same decoder block.

As a consequence, the transistor **M20̸** is in a conduction state (**ON**) while the transistor **M30̸** is cut off (**OFF**), thus the node **C** takes a "**0̸**" logic state and by means of the inverter **INV0̸**, which drives the respective word line **WL0̸** , the voltage **VPC** is transferred onto the line **WL**0̸, as desired. The transistor **M40̸**, notwithstanding its initial state, is in an **OFF** condition at the end of the transition. The node **S** of the voltage transfer inverter **INV0̸** is held to ground potential during reading and programming phases. The transistor **M10̸** has the function of isolating, during a programming phase, the logic circuits which are supplied at a relatively low voltage (**VCC**) from the logic circuits which are supplied at a relatively high voltage (**VPC**), (which notably during the programming phase takes the value of **+12V**).

The other seven word lines, representatively **WLi**, where **i** = **1,7**, are deselected because the respective selection signals (**Pi**, **PNi**) insure that the relative transistors **M2i** are in a cut off condition and that the respective transistors **M3i** are in a conducting condition. For these reasons, the nodes **C** of the line selection circuits of deselected lines are in a high logic state and, because of the inverter **INVi**, the relative word lines **WLi** are maintained in a low logic state. The high logic state of the nodes **C** of the line selection circuits of deselected lines is ensured beside by the respective transistors **M3i** also by the transistors **M4i** which are conducting.

Assuming to be carrying out the erasing of the entire matrix, it won't be necessary to select a particular word line thereof, viceversa in **FLASH-EPROM** memories which may be erasable by selectable sectors, the selection of a certain number of word lines through a specific sector selection system may be effected. The operation of the circuit during an erasing phase is the following.

During erasing the voltage **VPC** may take the value of +**5V** (± **10%**), while the node **S** of the voltage transfer inverters **INVi** (where i = **0,7**) of all the selection circuits of the word lines to be erased may be biased advantageously to a negative voltage, commonly of about **-6V**, as noted before. The nodes **C** of the various selection circuits of the word lines are biased at +**5V**, independently of the voltage of the node **B** of the selection block. This condition is realized by means of a particular configuration of the control signals P and **PN**, which ensures that the transistors **M2i** are OFF and the transistors **M3i** are ON.

In these conditions, by virtue of the peculiar structure of the inverter **INVi** of each word line selection circuit, in accordance with the present invention, the negative voltage which is applied to the supply node **S** of the transfer inverter may be transferred to the respective word line **WLi** without causing any biasing problem in the semiconducting substrate of the integrated circuit. The transistors **M4i**, which are also conducting during an erasing phase, contribute to maintain the respective nodes **C** of the circuits to the voltage of +**5V** (i.e. to the actual **VPC** voltage).

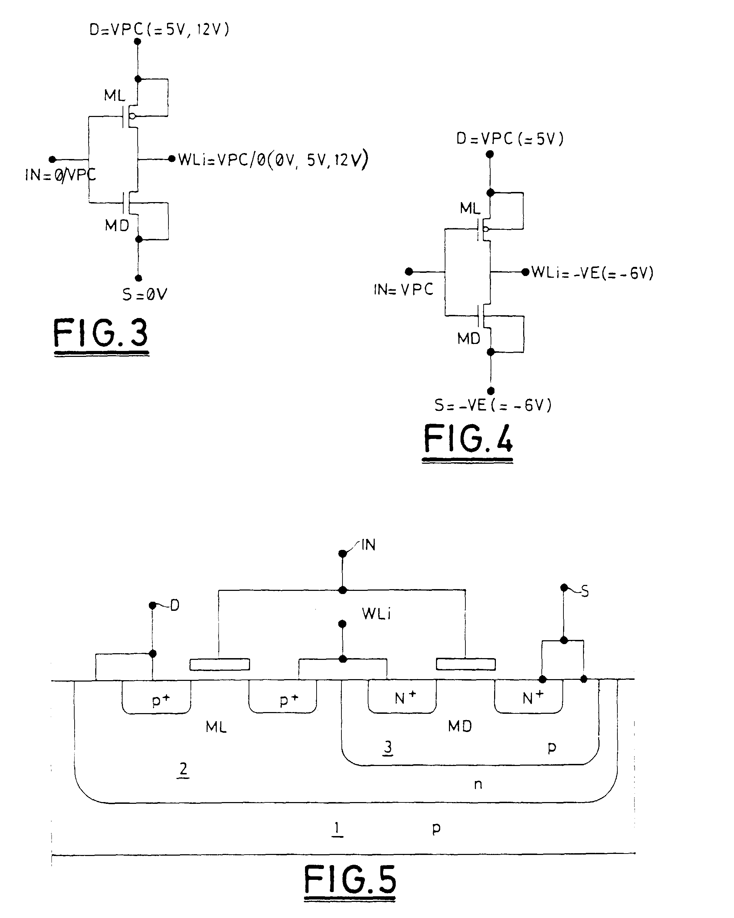

A symbolic illustration of the voltage transfer inverter circuit **INVi** of the word line selection circuits of the invention, relative to an operative condition during a reading or a programming phase of the memory is depicted in **Fig. 3,** while a similar symbolic illustration relative to an operative condition of the same inverter during an erasing phase is depicted in **Fig. 4.**

The supply node S of the word line driving inverters is at ground potential (**S** = **0̸V**) during reading and programming of the memory and by contrast is biased with a negative voltage (**S** = -**VE** = -**6V**), i.e. of a sign opposite to the sign of the supply voltages **VPC** (and **VCC**), during an erasing phase.

In function of the voltage signal which is applied to the input node **IN** of the inverter, which corresponds to 0̸V (in a deselection condition) or to the actual **VPC** voltage level (in a selection condition) during the reading (**VPC** = +**5V**) and programming (**VPC** = +**12V**), as depicted in **Fig. 3**, a correct biasing of the relative word line is ensured. The signal which is applied to the input node of the inverter will be equal to **VPC** (**VPC** = +**5V**) during an erasing phase, as depicted in **Fig. 4**. Therefore on the relative word line **WLi** either a positive voltage, **VPC**, (**Fig. 3**) or a negative voltage, -**VE**, (**Fig. 4**) is transferred.

In **Fig. 5** a symbolic vertical cross section of the integrated structure of the inverter **INVi** of the word line selection circuits and whose function has been depicted in **Figures 3** and **4** is shown, as made in accordance with the present invention.

In the example depicted, the circuit is integrated in a semiconducting substrate **1** having a **p**-type conductivity, as it is normally the case for these types of devices. The region **2** having an **n**-type conductivity and into which is customarily formed a **p**-channel load transistor (**ML**) of an inverter integrated in such a **p**-type substrate is, in the case of the circuit of the present invention, widened in order to geometrically contain also the **n**-channel driver transistors (**MD**) of the inverter. The **n**-channel driver transistor **MD** of the inverter is formed within a region 3, having a **p**-type conductivity, which is formed within the **n**-type region 2.

It is from this peculiar structure that the inverter **INVi** derives its ability to transfer also negative voltages, through its output node, to the driven word line **WLi**. In fact, the substrate of the **n**-channel driver transistors **MD** of the inverter, which is actually represented by the p-type region **3**, may be biased in a substantially independent manner from the rest of the substrate **1** of the integrated circuit and in particular, may be electrically connected to the relative circuit node **S** onto which both positive and negative voltages may be selectively applied. In other words, in the shown example, to the **S** node of the voltage transferring inverter a negative erasing voltage may be applied without causing a direct biasing of the drain and source junctions of the driver transistor **MD** of the inverter, a condition which would be incompatible with a proper functioning of the inverter.

Of course a voltage of the correct sign may be applied to the **S** node of the inverter circuit in different ways. One of the commonly used methods for switching a certain voltage to the node **S** of the voltage transfer inverter for a particular word line, is that of utilizing a switching circuit capable of switching to the node **S** of the inverter either the ground potential of the circuit, the supply voltage **VCC** or a negative voltage -**VE**, which may be generated by means of a common negative voltage pump circuit which may be activated by means of a control signal.

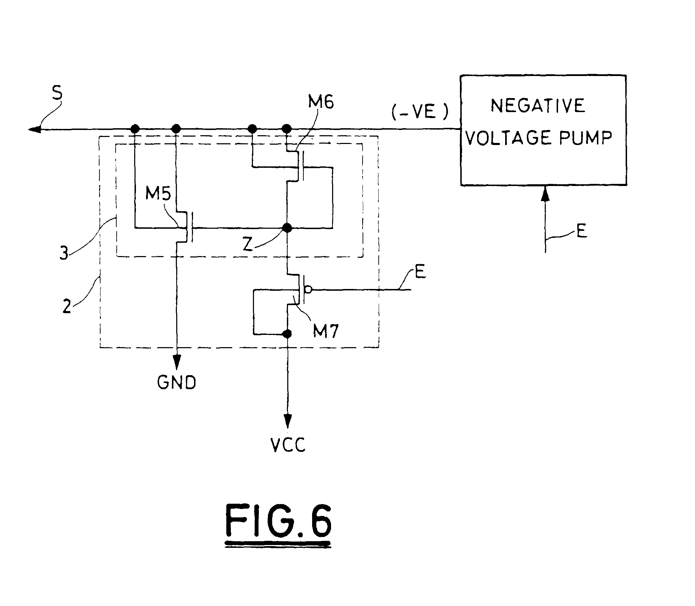

An embodiment of a suitable switching circuit is depicted in **Fig. 6**. A negative voltage generating pump circuit is symbolically indicated in **Fig. 6** and is enabled by feeding an enabling signal **E** thereto, in order to generate on an output node which is directly wired to the S node of the transfer inverter of **Figures 3, 4** and **5**, a negative erasing voltage. The negative voltage pump circuit may be any one known circuit customarily used for such a negative voltage generating function.

The switching circuit is formed by a **p**-channel transistor **M7** and by two **n**-channel transistors **M5** and **M6**, the latter being in a diode-configuration. According to the present invention, the two **n**-channel transistors **M5** and **M6** are not directly formed in the **p**-type substrate **1**, by contrast they are formed in a **p**-well-region **3** having a **p**-type conductivity which is formed within an **n**-tub region **2** where the **p**-channel transistor **M7** is formed as symbolically shown by the perimeters drawn with dash lines of said diffused regions **3** and **2**. Essentially this reproduces the same situation as the one which has already been described in **Fig. 5** for the pair of complementary transistors which compose the inverter **INVi**. This permits to bias the actual "substrate" of the transistors **M5** and **M6** independently of and without affecting the bias conditions of the substrate **1** of all the other **n**-channel devices of the integrated circuit.

During an erasing phase, the **S** node may be biased with a negative erasing voltage. The enabling signal **E** is brought to a high logic state and activates the negative voltage pump circuit, which delivers through its output terminal to the **S** node a negative erasing voltage (-**VE**). The same enabling signal **E** is also fed to the gate of the **p**-channel transistor **M7** switching it to an **OFF** condition and because the diode-configured **n**-channel transistor **M6** is conducting, the node **Z** assumes the same voltage as the node **S** and therefore the transistor **M5** is in an **OFF** condition. The negative erasing voltage (-**VE**) may then be transferred on the word lines of the memory matrix through the inverter, as described above.

During programming/reading phases, the **S** node must be kept at ground potential. The signal **E** is brought to a low logic state and in this way the negative voltage pump is deactivated. The **p**-channel transistor **M7** is made conducting and the node **Z** is brought to the **VCC** voltage thus causing the discharge of the **S** node which, not being kept at a negative voltage by the charging pump circuit, tends to discharge toward ground potential. The transistors **M5** is conducting and therefore contributes to quickly discharge the **S** node toward ground potential.

Notwithstanding the fact that the invention has been illustrated by describing preferred embodiments thereof, it is evident the duality of the considerations which have been made and the circuit may be realized also by inverting all types of conductivities and of polarities.

The advantages procured by the circuit of the invention are evident in terms of the extreme simplification of the word line decoding circuits capable of transferring voltages of opposite signs to the lines, in respect to the arrangements of the prior art and therefore also in terms of a reduced area requirement of the circuits.

## Claims

1. An integrated word line decoding circuit for an electrically programmable and erasable memory, comprising a selection circuit for each word line capable of transferring positive and negative voltages, functionally constituted by an inverter (INVi) having an input node (Ci) to which a voltage signal is fed, an output node connected to a respective word line (WLi), a first supply node (VPC) connected to a voltage source of a first sign and a second supply node (S) which is connected to ground potential during reading and programming and to a source of a voltage of an opposite sign (-VE) in respect to said first sign during erasing of the memory, characterized in that
said inverter is formed by a driver transistor (MD) of a first type of conductivity and a load transistor (ML) of a second type of conductivity functionally connected in series between said two supply nodes (VPC, S), the load transistor (ML) being contained within a region (2) of said first type of conductivity of a semiconducting substrate (1) of said second type of conductivity and the driver transistor (MD) being contained within a second region (3) of said second type of conductivity which is contained within said first region (2).

2. An integrated decoding circuit as defined in claim 1, wherein connection of said second supply node (S) of said inverter takes place through a switching circuit formed by a first transistor (M5) of said first type of conductivity which is functionally connected between said second supply node (S) and ground (GND), a diode-configured second transistor (M69 of said first type of conductivity connected in series with a third transistor (M7) of said second type of conductivity between said second supply node (S) and a supply node (VCC) of said first sign; said third transistor (M7) having a control terminal to which an enabling signal (E), which is also fed to a circuit generating a voltage of said opposite sign (NEGATIVE VOLTAGE PUMP) on an output terminal which is connected to said second supply node (-VE), is fed;
said first (M5) and second (M6) transistors of said first type of conductivity being contained within a region (3) of said second type of conductivity which is contained within a region (2) of said first type of conductivity inside which said third transistor (M7) is formed.

3. An integrated circuit as defined in claim 2, wherein said regions (2, 3) are the same regions of the integrated inverter circuit of claim 1.

4. An integrated circuit as defined in claim 1, wherein said substrate (1) has a p-type conductivity, said driver transistor (MD) is an n-channel transistor which is formed in a p-type region (3), which is contained within an n-type region (2), into which said p-channel load transistor (ML) is formed.

5. A word line decoding circuit as defined in any one of the preceding claims 1 to 4 being comprised in a FLASH-EPROM memory device which is erasable by applying a negative voltage to a control gate (WLi) in order to reduce the electric field intensity across a source junction, said word line decoding circuit being formed by a selection circuit for each word line which is capable of transferring positive and negative voltages and which is formed by an inverter (INVi) having an input node (Ci) onto which a voltage signal is fed, an output node connected to a respective word line (WLi), a first supply node connected to a supply voltage (VPC) of a first sign and a second supply node (S) connected to ground (GDN) during reading and programming and to a voltage of an opposite sign (-VE) in respect to said first sign during erasing of the memory device.

## Patentansprüche

1. Integrierte Wortleitungsdecodierungsschaltung für einen elektrisch programmierbaren und löschbaren Speicher, die für jede Wortleitung eine Wählschaltung enthält, die positive und negative Spannungen übertragen kann und funktional durch einen Inverter (INVi) gebildet ist, der versehen ist mit einem Eingangsknoten (Ci), an den ein Spannungssignal geliefert wird, einem Ausgangsknoten, der an eine entsprechende Wortleitung (WLi) angeschlossen ist, einem ersten Versorgungsknoten (VPC), der an eine Spannungsquelle mit einem ersten Vorzeichen angeschlossen ist, und einem zweiten Versorgungsknoten (S), der während des Lesens und Programmierens des Speichers an ein Massepotential und während des Löschens des Speichers an eine Spannungsquelle mit einem in bezug auf das erste Vorzeichen entgegengesetzten Vorzeichen (-VE) angeschlossen ist, dadurch gekennzeichnet daß,
der Inverter durch einen Treibertransistor (MD) eines ersten Leitfähigkeitstyps und durch einen Lasttransistor (ML) eines zweiten Leitfähigkeitstyps gebildet ist, die zwischen die beiden Versorgungsknoten (VPC, S) funktional in Serie geschaltet sind, wobei der Lasttransistor (ML) in einem Bereich (2) des ersten Leitfähigkeitstyps eines Halbleitersubstrats (1) des zweiten Leitfähigkeitstyps enthalten ist und der Treibertransistor (MD) in einem zweiten Bereich (3) des zweiten Leitfähigkeitstyps enthalten ist, der im ersten Bereich (2) enthalten ist.

2. Integrierte Decodierungsschaltung nach Anspruch 1, wobei eine Verbindung des zweiten Versorgungsknotens (S) des Inverters über eine Umschaltschaltung erfolgt, die durch einen ersten Transistor (M5) des zweiten Leitfähigkeitstyps, der funktional zwischen den zweiten Versorgungsknoten (S) und Masse (GND) geschaltet ist, und einen als Diode konfigurierten zweiten Transistor (M6) des ersten Leitfähigkeitstyps, der mit einem dritten Transistor (M7) des zweiten Leitfähigkeitstyps zwischen dem zweiten Versorgungsknoten (S) und einem Versorgungsknoten (VCC) mit dem ersten Vorzeichen in Serie geschaltet ist, gebildet ist; wobei der dritte Transistor (M7) einen Steueranschluß besitzt, an den ein Freigabesignal (E) geliefert wird, das außerdem an eine Schaltung geliefert wird, die an einem an den zweiten Versorgungsknoten (-VE) angeschlossenen Ausgangsanschluß eine Spannung mit entgegengesetztem Vorzeichen (NEGATIVE SPANNUNGSPUMPE) erzeugt;
wobei der erste (M5) und der zweite (M6) Transistor des ersten Leitfähigkeitstyps in einem Bereich (3) des zweiten Leitfähigkeitstyps enthalten sind, der in einem Bereich (2) des ersten Leitfähigkeitstyps enthalten ist, in dem der dritte Transistor (M7) ausgebildet ist.

3. Integrierte Schaltung nach Anspruch 2, wobei die Bereiche (2, 3) die gleichen Bereiche der integrierten Inverterschaltung nach Anspruch 1 sind.

4. Integrierte Schaltung nach Anspruch 1, wobei das Substrat (1) eine p-Leitfähigkeit hat, der Treibertransistor (MD) ein n-Kanal-Transistor ist, der in einem p-Bereich (3) gebildet ist, der in einem n-Bereich (2) enthalten ist, in dem der p-Lasttransistor (ML) gebildet ist.

5. Wortleitungsdecodierungsschaltung nach irgendeinem der vorangehenden Ansprüche 1 bis 4, die in einer FLASH-EPROM-Speichervorrichtung enthalten ist, die durch Anlegen einer negativen Spannung an ein Steuergerät (WLi) löschbar ist, um die Intensität des elektrischen Feldes über einem Source-Übergang zu reduzieren, wobei die Wortleitungsdecodierungsschaltung durch eine Wählschaltung für jede Wortleitung gebildet ist, die positive und negative Spannungen übertragen kann und durch einen Inverter (INVi) gebildet ist, der versehen ist mit einem Eingangsknoten (Ci), an den ein Spannungssignal geliefert wird, einem Ausgangsknoten, der an eine entsprechende Wortleitung (WLi) angeschlossen ist, einem ersten Versorgungsknoten, der an eine Versorgungsspannung (VPC) mit einem ersten Vorzeichen angeschlossen ist, sowie einem zweiten Versorgungsknoten (S) der während des Lesens und Programmierens der Speichervorrichtung an Masse (GDN) angeschlossen ist und während des Löschens der Speichervorrichtung an eine Spannung mit einem in bezug auf das erste Vorzeichen entgegengesetzten Vorzeichen (-VE) angeschlossen ist.

## Revendications

1. Circuit intégré de décodage de ligne de mot pour une mémoire électriquement programmable et effaçable, comprenant un circuit de sélection pour chaque ligne de mot capable de transférer des tensions positives et négatives, constitué fonctionnellement d'un inverseur (INVi) ayant un noeud d'entrée (Ci) auquel est appliqué un signal de tension, une sortie connectée à une ligne de mot respective (WLi), un premier noeud d'alimentation (VPC) connecté à une source de tension d'un premier signe, et un second noeud d'alimentation (S) connecté au potentiel de la masse pendant la lecture et la programmation et à une source de tension (-VE) de signe opposé au premier signe pendant l'effacement de la mémoire, caractérisé en ce que :
cet inverseur est constitué d'un transistor de commande (MD) d'un premier type de conductivité et d'un transistor de charge (ML) d'un second type de conductivité fonctionnellement connectés en série entre les deux noeuds d'alimentation (VPC, S), le transistor de charge (ML) étant contenu dans une région (2) du premier type de conductivité d'un substrat semiconducteur (1) du second type de conductivité et le transistor de commande (MD) étant contenu dans une seconde région (3) du second type de conductivité qui est contenue dans la première région (2).

2. Circuit intégré de décodage selon la revendication 1, dans lequel la connexion du second noeud d'alimentation (S) de l'inverseur prend place par l'intermédiaire d'un circuit de commutation constitué d'un premier transistor (M5) du premier type de conductivité qui est fonctionnellement connecté entre le second noeud d'alimentation (S) et la masse (GND), un second transistor connecté en diode (M6) du premier type de conductivité connecté en série avec un troisième transistor (M7) du second type de conductivité entre le second noeud d'alimentation (S) et un noeud d'alimentation (VCC) du premier signe ; le troisième transistor (M7) ayant une borne de commande à laquelle est fourni un signal de validation (E) qui est également fourni à un circuit produisant une tension dudit signe opposé sur une borne de sortie qui est connectée au second noeud d'alimentation (-VE) ;
les premier (M5) et second (M6) transistors du premier type de conductivité étant contenus dans une région (3) du second type de conductivité qui est contenue dans une région (2) du premier type de conductivité à l'intérieur de laquelle est formé le troisième transistor (M7).

3. Circuit intégré selon la revendication 2, dans lequel lesdites régions (2, 3) sont les mêmes régions que celles du circuit intégré inverseur de la revendication 1.

4. Circuit intégré selon la revendication 1, dans lequel le substrat (1) a un type de conductivité P, le transistor de commande (MD) est un transistor à canal N qui est constitué dans une région de type P (3) qui est contenue dans une région de type N (2), dans laquelle est formé le transistor de charge à canal P (ML).

5. Circuit de décodage de ligne de mot tel que défini dans l'une quelconque des revendications précédentes 1 à 4, étant constitué dans un dispositif de mémoire FLASH-EPROM effaçable en appliquant une tension négative à une grille de commande (WLi) pour réduire l'intensité du champ électrique aux bornes d'une jonction de source, le circuit de décodage de ligne de mot étant constitué d'un circuit de sélection pour chaque ligne de mot qui peut transférer des tensions positives et négatives et qui est constitué d'un inverseur (INVi) ayant un noeud d'entrée (Ci) sur lequel est fourni un signal de tension, un noeud de sortie connecté à une ligne de mot respective (WLi), un premier noeud d'alimentation connecté à une tension d'alimentation (VPC) d'un premier signe et un second noeud d'alimentation (S) connecté à la masse (GND) pendant la lecture et la programmation et à une tension (-VE) de signe opposé au premier signe pendant l'effacement du dispositif de mémoire.
